# EUROPEAN PATENT APPLICATION

(11) **EP 4 207 514 A1**
(43) Date of publication of application: **05.07.2023**
(21) Application number: 22155253.2
(22) Date of filing: 04.02.2022
(51) Int. Cl.: H01S 5/02, H01S 5/0225, G02B 6/12, H01S 5/12, H01S 5/00, H01S 5/40, H01S 5/026, H01S 5/0683

(54) **SILICON PHOTONIC SYMMETRIC DISTRIBUTED FEEDBACK LASER**

(30) Priority: 30.12.2021 US 202117566318
(71) Applicant: Juniper Networks, Inc., Sunnyvale, CA 94089 (US)
(72) Inventor: PARKER, John, Sunnyvale, 94089 (US); PIELS, Molly, Sunnyvale, 94089 (US); SHI, Hanxing, Sunnyvale, 94089 (US)
(74) Representative: D Young & Co LLP

(57) **Abstract**

A symmetric distributed feedback (DFB) laser that is integrated in a silicon based photonic integrated circuit can output light from both sides of the symmetric DFB laser onto waveguides. The light in the waveguides can be phase adjusted and combined using an optical coupler. The symmetric DFB laser can generate light and symmetrically output light onto different lanes of a multi-lane transmitter.

## Description

### TECHNICAL FIELD

The present disclosure generally relates to optical devices and more particularly to optical sources.

### BACKGROUND

A tunable laser is a laser in which the wavelength of operation can be altered in a controlled manner using filters to output the target wavelength. The tuning values vary over temperature and can require complex control systems to keep the tunable laser aligned during operation. A fixed laser is simpler to control; however, it is difficult to implement fixed lasers in photonic integrated circuits (PICs) due to calibration issues, power issues, and process control issues, such as process variation exhibited in modern PIC fabrication techniques.

### SUMMARY

Particular aspects are set out in the appended independent claims. Various optional embodiments are set out in the dependent claims.

### BRIEF DESCRIPTION OF THE DRAWINGS

The following description includes discussion of figures having illustrations given by way of example of implementations of embodiments of the disclosure. The drawings should be understood by way of example, and not by way of limitation. As used herein, references to one or more "embodiments" are to be understood as describing a particular feature, structure, or characteristic included in at least one implementation of the inventive subject matter. Thus, phrases such as "in one embodiment" or "in an alternate embodiment" appearing herein describe various embodiments and implementations of the inventive subject matter, and do not necessarily all refer to the same embodiment. However, they are also not necessarily mutually exclusive. To easily identify the discussion of any particular element or act, the most significant digit or digits in a reference number refer to the figure ("FIG.") number in which that element or act is first introduced.
FIG. 1 shows a silicon based distributed feedback (DFB) laser architecture, according to some example embodiments.
FIG. 2 shows an example multi-lane silicon fabricated low-loss DFB laser architecture, according to some example embodiments.
FIG. 3 shows an example a multi-lane silicon fabricated low-loss DFB architecture in which each symmetric DFB laser drives two lanes of a multi-lane architecture, according to some example embodiments.
FIG. 4 shows example symmetric DFB laser architectures that implement a Mach-Zehnder Modulator (MZM) for power combining, in accordance with some example embodiments.
FIG. 5 shows an example method for implementing a symmetric DFB device, according to some example embodiments.
FIG. 6 shows a flow diagram of a method for calibration of a symmetric DFB optical device, according to some example embodiments.
FIG. 7 shows an example optical transceiver, according to some example embodiments.
FIG. 8 is a diagram showing a side view of an optical-electrical device, according to some example embodiments.
FIGs. 9A and 9B show an approach for fabricating one or more symmetric DFB lasers having vertical III-V gratings, according to some example embodiments.

Descriptions of certain details and implementations follow, including a description of the figures, which may depict some or all of the embodiments described below, as well as discussing other potential embodiments or implementations of the inventive concepts presented herein. An overview of embodiments of the disclosure is provided below, followed by a more detailed description with reference to the drawings.

### DETAILED DESCRIPTION

In the following description, for the purposes of explanation, numerous specific details are set forth in order to provide an understanding of various embodiments of the inventive subject matter. It will be evident, however, to those skilled in the art, that embodiments of the inventive subject matter may be practiced without these specific details. In general, well-known instruction instances, structures, and techniques are not necessarily shown in detail.

As discussed, a PIC can implement a tunable laser, in which the laser can be tuned to output light of different wavelengths. In some example embodiments, the tunable laser can implement one or more optical filters to obtain a target wavelength of the optical system. The tuning values can vary over different temperatures, which can necessitate fast control loops that are integrated close to the PIC to ensure the tuners are aligned during operation. A fixed wavelength silicon photonic laser with DFB can be configured in the PIC such that no wavelength calibration is required, which can reduce calibration cost and can further allow faster module bootup time, thereby reducing power consumption and simplifying laser control. A DFB laser can be implemented as an integrated PIC laser in which the laser resonator comprises of a periodic structure in the laser gain medium, which functions as a distributed Bragg reflector in the wavelength range of laser action. In some example embodiments, a distributed-feedback laser has multiple axial resonator modes, but there is typically one mode which is preferable in terms of losses; thus, single-frequency operation can be implemented.

While some non-silicon based DFB sources can implement anti-reflectivity (AR) and high-reflectivity (HR) coatings on the facets to obtain higher power, this approach is incompatible with silicon based photonic DFBs because coatings cannot be applied to facets of a silicon based photonic DFB. Additionally, the approaches waste power as the coatings have defects which can waste portions of the light (e.g., 20%). Additionally, these approaches exhibit poor feedback tolerance and are more sensitive to feedback and reflections. Additionally, applying the coating requires access to both the DFB output sides to apply the coatings, and coatings cannot be applied to silicon designs having integrated sources that are integrated in the middle the design, thereby making such access impossible.

To address the foregoing, a silicon photonic symmetric DFB can be implemented to provide light to the PIC in an approach that has a similar power efficiency as non-silicon photonic DFBs by utilizing power from both outputs of the silicon photonic symmetric DFB.

The bends in the routing of the silicon photonic symmetric DFB can be configured such that they are low loss and without reflection to the silicon photonic symmetric DFB, in contrast to bends of III-V based DFBs that cause high loss and high reflection and thus cannot be used to implement symmetric DFBs. In fiber based DFBs, large and expensive components are required to adjust and stabilize the phase of both outputs to combine them in a 2×1 coupler. The large size of fiber based DFB laser prevents their use in typical multiple lane transceivers such as ethernet applications (e.g., a multiple lane transceiver in which both laser outputs are utilized, such as combined for a single lane or each output running a separate lane).

In some example embodiments, a silicon photonic symmetric DFB is configured such that no wavelength adjustment is required in operation, which increases the power efficiency while achieving high optical mode stability. In some example embodiments, the silicon photonic symmetric DFB outputs to two waveguides and couples the light using a 2×1 optical combiner, in which the waveguides are fully symmetric waveguides to reduce phase errors, and thermal phase tuners provide optical phase matching at the input to the 2×1 optical combiner which outputs the optical beam. In some example embodiments, the silicon photonic symmetric DFB outputs to two different waveguides which drive separate optical lanes with the same operating wavelength, which achieves high power efficiency due to the optical power from both output ports being used.

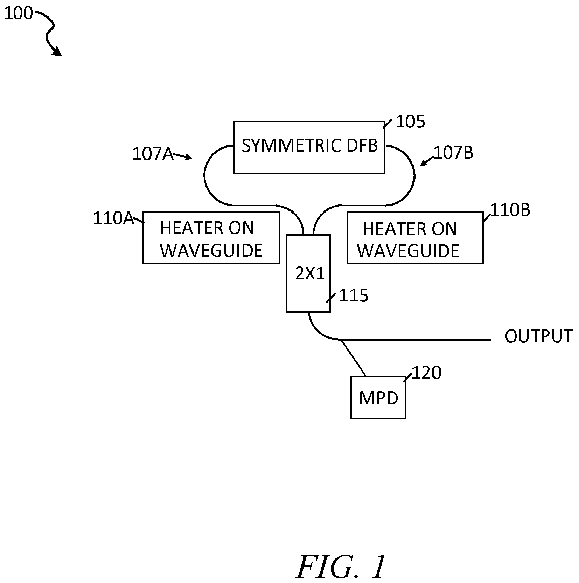

FIG. 1 shows a silicon based DFB laser architecture 100, according to some example embodiments. In the example of FIG. 1, a silicon based DFB laser 105 has symmetric gratings and a symmetric cavity design. In some example embodiments, each of the gratings has a coupling constant (kappa) that is symmetric around a center or can vary (e.g., periodically) across the length of the DFB. The light is output from both sides of the silicon based DFB laser 105 into output waveguides, including a first waveguide 107A and a second waveguide 107B. The light output to the waveguides is not perfectly in phase (e.g., due to manufacturing variations) and can be phase adjusted using heaters, such as heater 110A and heater 110B (e.g., resistive metal on top of a given waveguide). In some example embodiments, the waveguides are coiled under their respective heaters via s-bends in the silicon architecture such that the heater power can be reduced. The light from the first waveguide 107A and second waveguide 107B is then combined in a coupler 115 (e.g., multimode interference (MMI) coupler, directional coupler, Y-junction coupler). In some example embodiments, a portion of the output from the coupler 115 is tapped into a monitor photodiode 120 for measuring the power levels for calibration and operation, as discussed in further detail below.

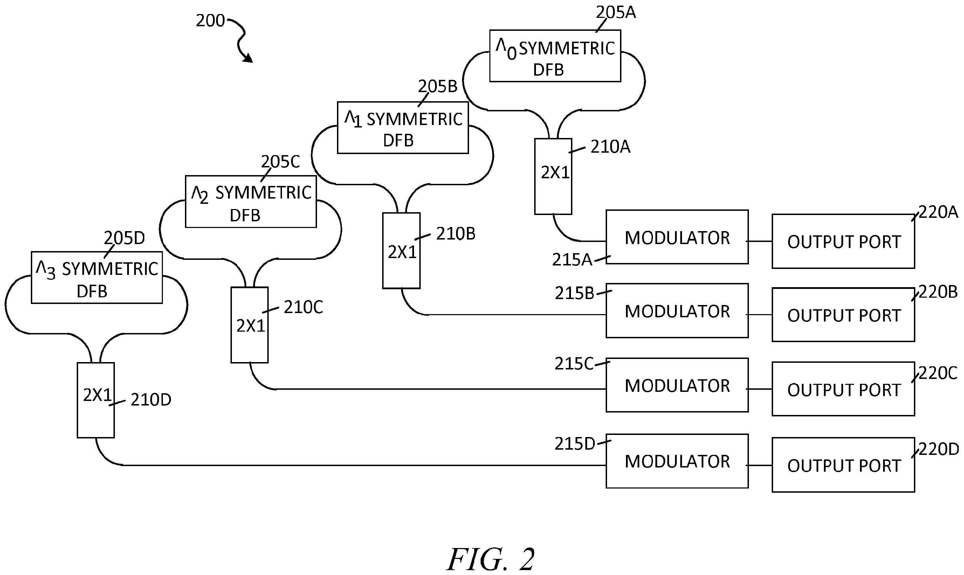

FIG. 2 shows a multi-lane silicon based DFB laser architecture 200, according to some example embodiments. The multi-lane silicon based DFB laser architecture 200 is an example of a coarse wavelength division multiplexing (CWDM) transmitter architecture (e.g., 400G-FR4 application) that can be integrated in a multi-lane transceiver PIC (e.g., 700). As illustrated, the first symmetric DFB laser 205A (e.g., set to a first wavelength) outputs to a coupler 210A, which combines the light, which is then modulated by the modulator 215A (e.g., electroabsorption modulator) and output via an output port 220A. In the example of FIG. 2, the heaters are omitted for clarity in FIG. 2.

Continuing, the second symmetric DFB laser 205B (e.g., set to a second wavelength that is higher than the first wavelength) outputs to a coupler 210B, which combines the light, which is then modulated by the modulator 215B and output via an output port 220B. Further, the third symmetric DFB laser 205C (e.g., set to a third wavelength that is higher than the second wavelength) outputs to a coupler 210C, which combines the light, which is then modulated by the modulator 215C and output via an output port 220C. Further, the fourth symmetric DFB laser 205D (e.g., set to a fourth wavelength that is higher than the third wavelength) outputs to a coupler 210D, which combines the light, which is then modulated by the modulator 215D and output via an output port 220D.

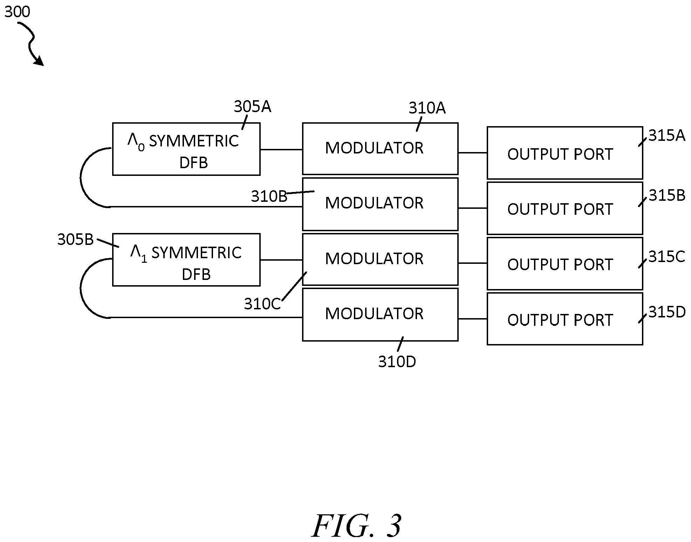

FIG. 3 shows an example a multi-lane silicon based DFB architecture 300 in which each symmetric DFB drives two lanes of a multi-lane architecture, according to some example embodiments. In particular, one side of the silicon photonic integrated symmetric DFB laser 305A can provide light of a given wavelength (e.g., Λ₀) for a first lane in which the light is modulated by a modulator 310A and then output via output port 315A, where the components are coupled via low-loss integrated silicon waveguides all fabricated together. Further, the other side of the silicon photonic integrated symmetric DFB laser 305A provides light of the given wavelength (e.g., Λ₀) for a second lane, where the light is modulated by a modulator 310B and then output via output port 315B, where the first and second lanes receive half of the light power provided by the silicon photonic integrated symmetric DFB laser 305A.

Similarly, for the third and fourth lanes, one side of the silicon photonic integrated symmetric DFB laser 305B can provide light of a given wavelength (e.g., Λ₁) for a third lane in which the light is modulated by a modulator 310C and then output via output port 315C. Further, the other side of the silicon photonic integrated symmetric DFB laser 305B provides light of the given wavelength (e.g., Λ₁) for a fourth lane, where the light is modulated by a modulator 310D and then output via output port 315D, where the third and fourth lanes receive half of the light power provided by the silicon photonic integrated symmetric DFB laser 305B. In some example embodiments, the multi-lane silicon based DFB architecture 300 does not include heaters, and the light emanating from either side of the silicon photonic integrated symmetric DFB laser 305A may be out of phase, but the light from the different sides are not combined (e.g., in a 2×1 coupler as in FIG. 1 and FIG. 2). In some example embodiments, the multi-lane silicon based DFB architecture 300 is a low power design in which the 305A and 305D are each 10mW silicon DFBs and DFBs in which the symmetric DFB outputs are combined are higher power designs in which the symmetric DFBs are each 20 mW silicon based DFBs.

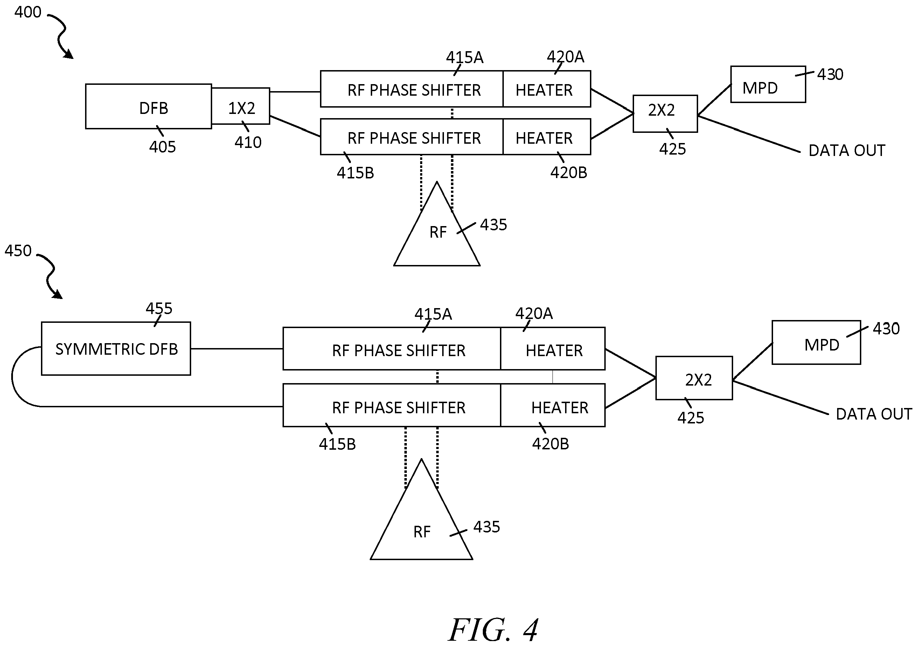

FIG. 4 shows example symmetric DFB architectures that implement a Mach-Zehnder Modulator (MZM) for power combining, in accordance with some example embodiments. A Mach-Zehnder modulator is an interferometric structure made from a material with an electro-optic effect (e.g., LiNbO3, GaAs, InP), in which electric fields are applied to the arms to change the optical path lengths, thereby resulting in phase modulation. In some example embodiments, combining two arms (e.g., via a 2x2 coupler) with different phase modulation converts phase modulation into intensity modulation. In the example architecture 400, a DFB 405 generates light that is split via a 1x2 coupler 410 into the upper and lower modulator arms. A radio frequency (RF) source 435 controls one or more phase shifters to implement modulation, such as an RF phase shifter 415A and an RF phase shifter 415B. Further, a heater 420A and heater 420B are implemented to compensate for phase imbalance in the arms. In some example embodiments, one of the heaters is activated to phase balance the arms to hold the MZM at the correct bias point for a differential high-speed signal applied to the RF phase shifters 415A and 415B to modulate the signal. The modulated light is then combined via a 2x2 coupler 425 and then output to a data output port and a monitor photodiode 430 for calibration and monitoring of the device.

The architecture 450 illustrates a low loss approach in which the 1x2 coupler 410 is omitted and instead a symmetric DFB 455 provides light for both lanes, as discussed above with reference to FIG. 3. In some example embodiments, the coupler 2x2 425 is also omitted from the silicon design and instead bias control is managed by an MZM bias control unit.

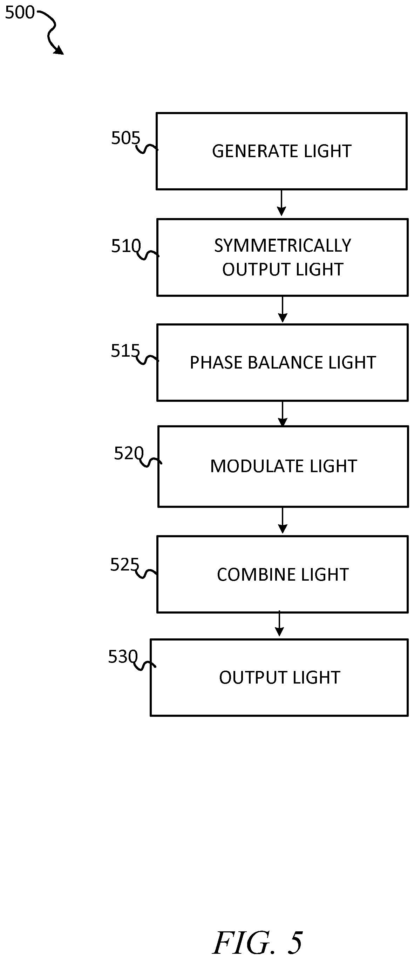

FIG. 5 shows a flow diagram of an example method 500 for implementing an optical device having one or more silicon fabricated low-loss symmetric DFB lasers that are fabricated with other components of the optical device in a PIC (e.g., waveguides, couplers), according to some example embodiments. At operation 505, a symmetric DFB laser generates light. For example, the silicon based DFB laser 105 generates light at a target wavelength. At operation 510, the generated light is symmetrically output from the symmetric DFB. For example, half of the generated light is output from one side of the DFB and the other half of the light is output from the other side of the symmetric DFB onto silicon waveguides. At operation 515, the light in the waveguides is phase balanced. For example, the light exiting from the opposite sides of the symmetric DFB are slightly out of phase due to fabrication variations (e.g., process variation), and one of the heaters (e.g., heater 110A, heater 110B) is activated to phase balance light in one of the waveguides. In some example embodiments, the symmetrically output light is output to different lanes of the transmitter and the heaters are omitted and operation 515 is skipped.

At operation 520, the light is combined. For example, with reference to FIG. 2, the phase corrected light is combined using a coupler 210A. In some example embodiments, the light is not combined and the output from each side of the symmetric DFB is output to different lanes and operation 520 is omitted.

At operation 525, the light is modulated. For example, the modulator 215A modulates light of the first lane, which is light from both sides of the first symmetric DFB laser 205A which is combined via coupler 210A. As an additional example, the modulator 310A in FIG. 3 modulates light that is output from one of the sides of the silicon photonic integrated symmetric DFB laser 305A.

At operation 530, the light is output from the device. For example, the each lane of light is output from respective output ports (e.g., output ports 220A-220D of FIG. 2, output ports 315A-315D of FIG. 3).

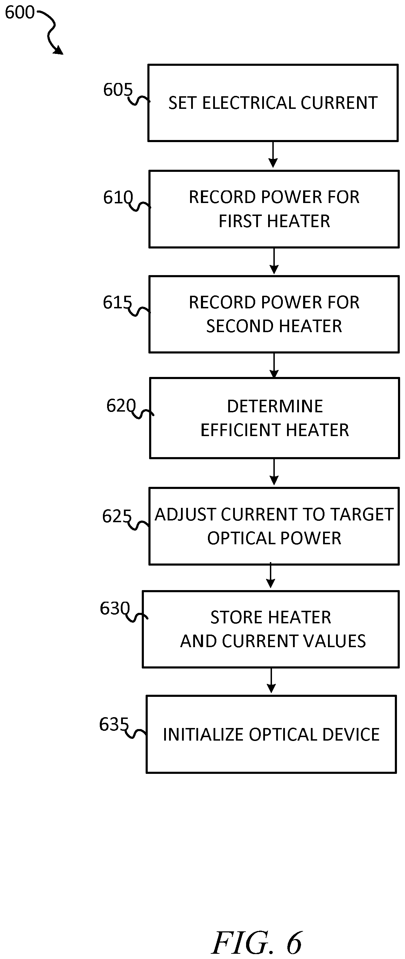

FIG. 6 shows a flow diagram of a method 600 for calibration of a symmetric DFB optical device, according to some example embodiments. An advantage of heater based architecture (e.g., silicon based DFB laser architecture 100) is that phase imbalance from the silicon based DFB laser 105 between the two arms can be compensated for after fabrication, and the phase adjustment requires only monitoring the optical tap power at the monitor photodiode 120.

In some example embodiments, heaters are added on both sides (e.g., heater 110A, heater 110B) but only one is used at a given time to compensate for small positive or negative phase imbalance, due to process variation in fabrication of the PIC having the symmetric DFBs. At operation 605, the electrical current for the symmetric DFB laser (e.g., silicon based DFB laser 105) is set to a nominal value (e.g., 100 milliamps). At operation 610, the maximum power for one of the heaters is recorded. For example, the power of the heater 110A is swept while the value of the monitor photodiode 120 is monitored, and the power value for the heater 110A is recorded when the monitor photodiode (MPD) reading is maximized.

At operation 615, the maximum power for another of the heaters is recorded. For example, the power of the heater 110B is swept while the value of the monitor photodiode 120 is monitored, and the power value for the heater 110B is recorded when the MPD reading is maximized.

At operation 620, it is determined whether heater 110A or heater 110B is more efficient (e.g., which has less power usage at maximum MPD reading) when the MPD reading is maximized, and heater power is applied to the most efficient of the heaters to phase balance the arms.

At operation 625, the electrical current of the symmetric DFB is adjusted until the target optical power is reached on MPD. At operation 630, the heater values and electrical current settings are saved to memory (e.g., flash memory) of the optical system (e.g., optical transceiver 700) to be implemented when the system is initialized for operation. In some example embodiments, the method 600 is performed multiple times for additional DFBs in the device (e.g., DFBs 205A-205D), and the respective values for each lane are stored at operation 630.

At operation 635, the optical system having the one or more symmetric DFBs is initialized for operation (e.g., in the field, in a product) and the stored values are applied to the one or more symmetric DFBs and one or more heaters for efficient operation of the optical device.

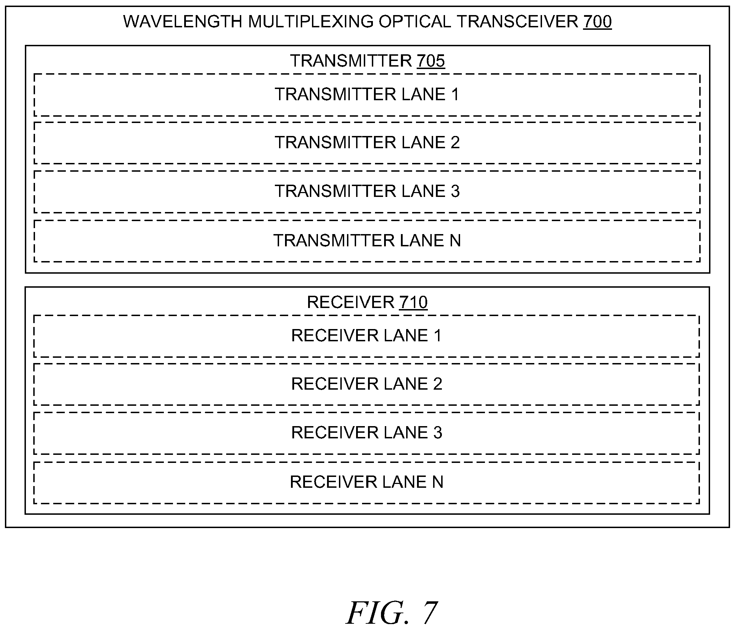

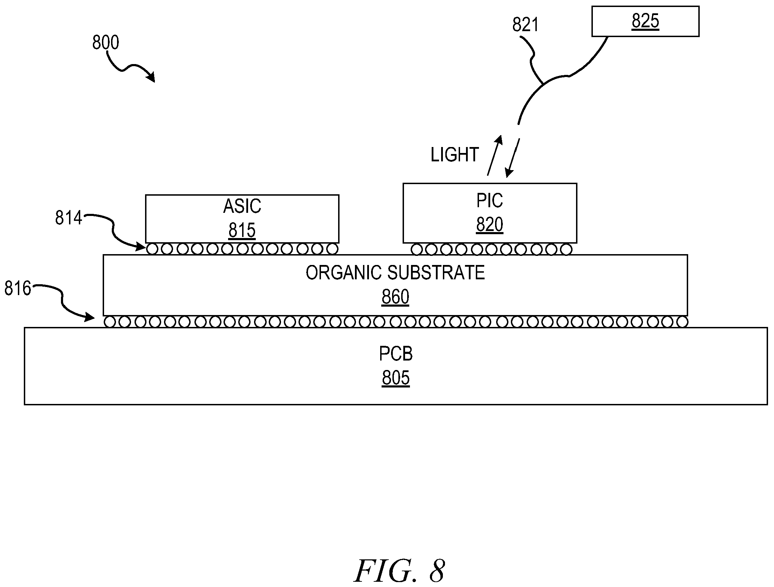

FIG. 7 shows a multi-lane wavelength division multiplexing optical transceiver 700, according to some example embodiments. In the illustrated embodiment, the optical transceiver 700 comprises an integrated photonic transmitter structure 705 and an integrated photonic receiver structure 710. In some example embodiments, the integrated photonic transmitter structure 705 and the integrated photonic receiver structure 710 are example optical components fabricated as a PIC device, such as PIC 820 of FIG. 8, discussed below. The integrated photonic transmitter structure 705 is an example of a dense wavelength division multiplexing (DWDM) transmitter having a plurality of lanes (transmitter lanes 1-N) in which each lane handles a different wavelength of light. The integrated photonic receiver structure 710 is an example of a DWDM receiver that receives DWDM light (e.g., from an optical network or from the integrated photonic transmitter structure 705 in loopback mode). The integrated photonic receiver structure 710 can receive and process light by filtering, amplifying, and converting it to electrical signal using components such as multiplexers, semiconductor optical amplifiers (SOAs), and one or more detectors such as photodetectors (e.g., photodiodes).

FIG. 8 shows a side view of an optical-electrical device 800 including one or more optical devices, according to some example embodiments. In illustrated embodiment, the optical-electrical device 800 is shown to include a printed circuit board (PCB) substrate 805, organic substrate 860, an application-specific integrated circuit 815 (ASIC), and PIC 820.

In some example embodiments, the PIC 820 includes silicon on insulator (SOI) or silicon based (e.g., silicon nitride (SiN)) devices, or may comprise devices formed from both silicon and a non-silicon material. Said non-silicon material (alternatively referred to as "heterogeneous material") may comprise one of III-V material, magneto-optic (MO) material, or crystal substrate material. III-V semiconductors have elements that are found in group III and group V of the periodic table (e.g., Indium Gallium Arsenide Phosphide (InGaAsP), Gallium Indium Arsenide Nitride (GainAsN)). The carrier dispersion effects of III-V-based materials may be significantly higher than in silicon-based materials, as electron speed in III-V semiconductors is much faster than that in silicon. In addition, III-V materials have a direct bandgap, which enables efficient creation of light from electrical pumping. Thus, III-V semiconductor materials enable photonic operations with an increased efficiency over silicon for both generating light and modulating the refractive index of light. Thus, III-V semiconductor materials enable photonic operation with an increased efficiency at generating light from electricity and converting light back into electricity.

The low optical loss and high quality oxides of silicon are thus combined with the electro-optic efficiency of III-V semiconductors in the heterogeneous optical devices described below; in embodiments of the disclosure, said heterogeneous devices utilize low loss heterogeneous optical waveguide transitions between the devices' heterogeneous and silicon-only waveguides.

MO materials allow heterogeneous PICs to operate based on the MO effect. Such devices may utilize the Faraday Effect, in which the magnetic field associated with an electrical signal modulates an optical beam, offering high bandwidth modulation, and rotates the electric field of the optical mode, enabling optical isolators. Said MO materials may comprise, for example, materials such as iron, cobalt, or yttrium iron garnet (YIG). Further, in some example embodiments, crystal substrate materials provide heterogeneous PICs with a high electro-mechanical coupling, linear electro-optic coefficient, low transmission loss, and stable physical and chemical properties. Said crystal substrate materials may comprise, for example, lithium niobate (LiNbO3) or lithium tantalate (LiTaO3).

In the example illustrated, the PIC 820 exchanges light with an external light source 825 via an optical fiber 821, in a flip-chip configuration where a topside of the PIC 820 is connected to the organic substrate 860 and light propagates out (or in) from a bottom-side of the PIC 820 facing away (e.g., towards a coupler), according to some example embodiments. The optical fiber 821 can couple with the PIC 820 using a prism, grating, or lens, according to some example embodiments. The optical components of PIC 820 (e.g., optical modulators, optical switches) are controlled, at least in part, by control circuitry included in ASIC 815. Both ASIC 815 and PIC 820 are shown to be disposed on copper pillars 814, which are used for communicatively coupling the PICs via organic substrate 860. PCB substrate 805 is coupled to organic substrate 860 via ball grid array (BGA) interconnect 816 and may be used to interconnect the organic substrate 860 (and thus, ASIC 815 and PIC 820) to other components of the optical-electrical device 800 not shown (e.g., interconnection modules, power supplies, etc.).

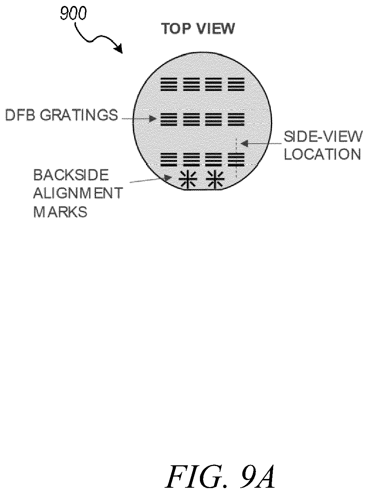

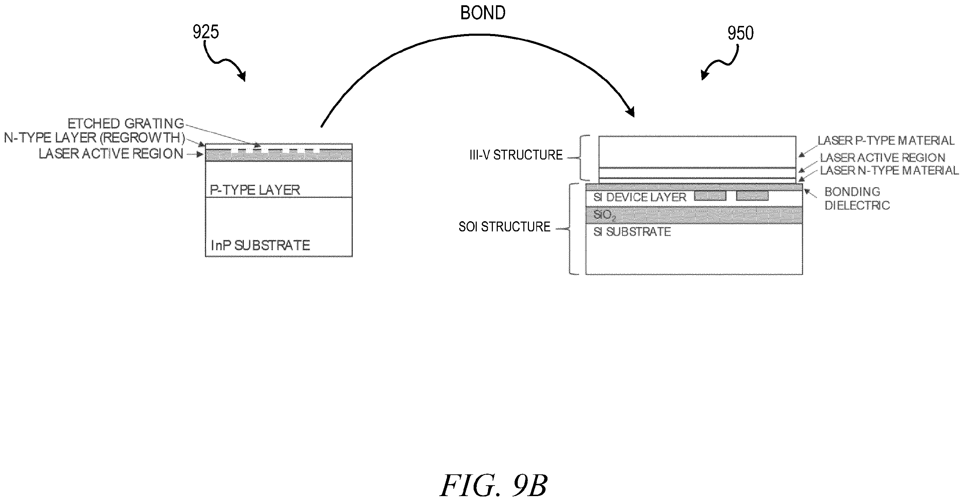

FIGs. 9A and 9B show an approach for fabricating one or more symmetric DFB lasers having vertical III-V gratings, according to some example embodiments. In FIG. 9A, a III-V structure 900 is partially grown. For example, a III-V wafer comprising one or more layers of InP, GaAs, AlAs, or InAs is partially grown. In some example embodiments, DFB gratings are then patterned on the III-V structure (e.g. using nano-imprint or electron-beam lithography). After the DFB gratings are patterned, the III-V structure 900 is then wet and/or dry etched, and additional layers of the III-V are grown to form etched III-V structure 925 (e.g., III-V epitaxial wafer), illustrated in FIG. 9B.

The etched III-V structure 925 is then bonded to the silicon structure (e.g., silicon wafer) to form the bonded structure 950 that includes one or more symmetric DFBs having the gratings. In some example embodiments, prior to bonding, a dielectric layer (e.g. SiO2, SiN, or Al2O3) is added to the surface of the etched III-V structure 925 to improve bonding. In some example embodiments, the etched III-V structure 925 is then cleaved into small rectangles (e.g., epitaxial dies) using the alignment marks on the etched III-V structure 925 to align cleave locations to the gratings. The etched III-V structure 925 (e.g., an epitaxial die) is then bonded to the SOI structure 950 to form the bonded structure 950. In some example embodiments, the bonded structure 950 is then further processed to form additional circuit components, and vias and metallic pads are integrated into the bonded structure 950 to provide current and drive the symmetric DFB laser.

Therefore from one perspective, there has been described a symmetric distributed feedback (DFB) laser that is integrated in a silicon based photonic integrated circuit can output light from both sides of the symmetric DFB laser onto waveguides. The light in the waveguides can be phase adjusted and combined using an optical coupler. The symmetric DFB laser can generate light and symmetrically output light onto different lanes of a multi-lane transmitter.

In view of the disclosure above, various examples are set forth below. It should be noted that one or more features of an example, taken in isolation or combination, should be considered within the disclosure of this application.

The following are example embodiments:
Example 1. A silicon photonic integrated circuit comprising: a silicon distributed feedback laser comprising a first output side and a second output side that is opposite of the first output side; a plurality of silicon waveguides comprising a first waveguide to receive a first light beam from the first output side and a second waveguide to receive a second light beam from the second output side; a silicon combiner to combine the first light beam from the first output side with the second light beam from the second output side into a combined light beam; and a silicon output waveguide to output the combined light beam. Other embodiments of this aspect include corresponding computer systems, apparatus, and computer programs recorded on one or more computer storage devices, each configured to perform the actions of the methods.
Example 2. The silicon photonic integrated circuit of example 1, further comprising: a heater to apply heat to one of the plurality of silicon waveguides.
Example 3. The silicon photonic integrated circuit of any of examples 1 or 2, wherein the heater applies heat to phase match the first light beam and the second light beam, the first light beam and the second light beam being out of phase from the silicon distributed feedback laser.
Example 4. The silicon photonic integrated circuit of any of examples 1-3, wherein the heater is a first heater that is proximate to the first waveguide.
Example 5. The silicon photonic integrated circuit of any of examples 1-4, further comprising a second heater that is proximate to the second waveguide.
Example 6. The silicon photonic integrated circuit of any of examples 1-5, wherein the second heater is configured to remain inactive while the first heater applies heat to phase match the first light beam and the second light beam.
Example 7. The silicon photonic integrated circuit of any of examples 1-6, further comprising control circuitry configured to activate the first heater to apply heat while the second heater is inactive.
Example 8. The silicon photonic integrated circuit of any of examples 1-7, wherein the control circuitry is configured to activate the first heater while the second heater being inactive based on calibrations performed on the first heater and the second heater.
Example 9. The silicon photonic integrated circuit of any of examples 1-8, wherein the control circuitry is further configured to apply a drive current to the silicon distributed feedback laser.
Example 10. The silicon photonic integrated circuit of any of examples 1-9, further comprising: an optical modulator to modulate the combined light beam.
Example 11. The silicon photonic integrated circuit of any of examples 1-10, wherein the silicon photonic integrated circuit is monolithically fabricated, and the silicon distributed feedback laser, the plurality of silicon waveguides, and the silicon combiner are formed from a same silicon wafer.
Example 12. The silicon photonic integrated circuit of any of examples 1-11, wherein the plurality of waveguides comprise low optical loss bends to couple light from the silicon distributed feedback laser to the silicon combiner.
Example 13. The silicon photonic integrated circuit of any of examples 1-12, wherein one or more of the plurality of waveguides comprises a bend that is proximate to a heater in the silicon photonic integrated circuit to reduce heater power for phase matching.
Example 14. The silicon photonic integrated circuit of any of examples 1-13, wherein the silicon distributed feedback laser is a symmetric silicon distributed feedback laser configured to generate laser light and output a first half of the laser light out the first output side and output a second half of the laser light out the second output side.
Example 15. The silicon photonic integrated circuit of any of examples 1-14, wherein the silicon distributed feedback laser does not comprise reflectivity coatings on the first output side and the second output side.
Example 16. The silicon photonic integrated circuit of any of examples 1-15, wherein the silicon combiner is a multimode interference coupler.
Example 17. The silicon photonic integrated circuit of any of examples 1-16, wherein the silicon distributed feedback laser is a fixed source configured to generate light at a fixed wavelength.
Example 18. The silicon photonic integrated circuit of any of examples 1-17, wherein the silicon photonic integrated circuit is a wavelength division multiplexing based device that comprises a plurality of symmetric silicon distributed feedback lasers, each symmetric silicon distributed feedback laser configured to output light from opposite sides of the symmetric silicon distributed feedback laser.
Example 19. The silicon photonic integrated circuit of any of examples 1-18, wherein each of the plurality of symmetric silicon distributed feedback lasers are fixed sources. Implementations of the described techniques may include hardware, a method or process, or computer software on a computer-accessible medium.
Example 20. A method for generating light in a silicon photonic integrated circuit comprising: generating, by a silicon distributed feedback laser in the silicon photonic integrated circuit, first light beam and a second light beam; outputting the first light beam from a first output side of the silicon distributed feedback laser and outputting the second light beam from a second output side of the silicon distributed feedback laser, the first output side and the second output side being opposite sides of the silicon distributed feedback laser; receiving the first light beam using a first waveguide in the silicon photonic integrated circuit; receiving the second light beam using a second waveguide in the silicon photonic integrated circuit; combining the first light beam and the second light beam using a silicon combiner of the silicon photonic integrated circuit; and outputting the combined light beam using a silicon output waveguide of the silicon photonic integrated circuit. Other embodiments of this aspect include corresponding computer systems, apparatus, and computer programs recorded on one or more computer storage devices, each configured to perform the actions of the methods.
Example 21.A symmetric distributed feedback (DFB) laser fabricated from a silicon wafer by bonding compound semiconductor materials, wherein an optical power from both ports of the symmetric DFB laser is combined using phase-matched silicon waveguides and an optical power combiner. Other embodiments of this aspect include corresponding computer systems, apparatus, and computer programs recorded on one or more computer storage devices, each configured to perform the actions of the methods.
Example 22. The symmetric DFB laser of example 21, wherein the symmetric DFB laser is a quarter-wave-shifted DFB laser.
Example 23. The symmetric DFB laser of any of examples 21 or 22, wherein the symmetric DFB laser comprises a DFB grating.
Example 24. The symmetric DFB laser of any of examples 21-23, wherein the DFB grating comprises a Kappa that is symmetric around a center.
Example 25. The symmetric DFB laser of any of examples 21-24, wherein the DFB grating comprises a Kappa that is varied across a length of the symmetric DFB laser.
Example 26. The symmetric DFB laser of any of examples 21-25, wherein the DFB grating is formed with a lateral variation in a silicon waveguide width.
Example 27. The symmetric DFB laser of any of examples 21-26, wherein the DFB grating is formed with a vertical etch in a silicon waveguide.
Example 28. The symmetric DFB laser of any of examples 21-27, wherein the DFB grating is formed by etching one or more III-V layers.
Example 29. A symmetric distributed feedback (DFB) laser formed from a silicon wafer by bonding compound semiconductor materials, wherein an optical power from both ports of the symmetric DFB laser is used to drive two separate optical lanes with different data modulations. Other embodiments of this aspect include corresponding computer systems, apparatus, and computer programs recorded on one or more computer storage devices, each configured to perform the actions of the methods.
Example 30. The symmetric DFB laser of example 29, further comprising: a plurality of semiconductor optical amplifiers to increase an optical power of light from the symmetric DFB laser. Implementations of the described techniques may include hardware, a method or process, or computer software on a computer-accessible medium.
Example 31. A silicon photonic integrated circuit comprising: a silicon distributed feedback laser comprising a first output side and a second output side that is opposite of the first output side; a plurality of silicon waveguides comprising a first waveguide to receive a first light beam from the first output side and a second waveguide to receive a second light beam from the second output side; a silicon combiner to combine the first light beam from the first output side with the second light beam from the second output side into a combined light beam; and a silicon output waveguide to output the combined light beam.
Example 32. The silicon photonic integrated circuit of example 31, further comprising: a heater to apply heat to one of the plurality of silicon waveguides.
Example 33. The silicon photonic integrated circuit of example 32, wherein the heater applies heat to phase match the first light beam and the second light beam, the first light beam and the second light beam being out of phase from the silicon distributed feedback laser.
Example 34. The silicon photonic integrated circuit of example 32 or 33, wherein the heater is a first heater that is proximate to the first waveguide.
Example 35. The silicon photonic integrated circuit of example 34, further comprising a second heater that is proximate to the second waveguide.
Example 36. The silicon photonic integrated circuit of example 35, wherein the second heater is configured to remain inactive while the first heater applies heat to phase match the first light beam and the second light beam.
Example 37. The silicon photonic integrated circuit of example 35 or 36, further comprising control circuitry configured to activate the first heater to apply heat while the second heater is inactive.
Example 38. The silicon photonic integrated circuit of example 37, wherein the control circuitry is configured to activate the first heater while the second heater being inactive based on calibrations performed on the first heater and the second heater.
Example 39. The silicon photonic integrated circuit of example 37 or 38, wherein the control circuitry is further configured to apply a drive current to the silicon distributed feedback laser.
Example 40. The silicon photonic integrated circuit of any of examples 31 to 39, further comprising: an optical modulator to modulate the combined light beam.
Example 41. The silicon photonic integrated circuit of any of examples 31 to 40, wherein the silicon photonic integrated circuit is fabricated, and the silicon distributed feedback laser, the plurality of silicon waveguides, and the silicon combiner are formed using a same silicon wafer.
Example 42. The silicon photonic integrated circuit of example 41, wherein the plurality of silicon waveguides comprise low optical loss bends to couple light from the silicon distributed feedback laser to the silicon combiner.
Example 43. The silicon photonic integrated circuit of example 41 or 42, wherein one or more of the plurality of silicon waveguides comprises a bend that is proximate to a heater in the silicon photonic integrated circuit to reduce heater power for phase matching.
Example 44. The silicon photonic integrated circuit of any of examples 31 to 43, wherein the silicon distributed feedback laser is a symmetric silicon distributed feedback laser configured to generate laser light and output a first half of the laser light out the first output side and output a second half of the laser light out the second output side.
Example 45. The silicon photonic integrated circuit of any of examples 31 to 44, wherein the silicon distributed feedback laser does not comprise reflectivity coatings on the first output side and the second output side.
Example 46. The silicon photonic integrated circuit of any of examples 31 to 45, wherein the silicon combiner is a multimode interference coupler.
Example 47. The silicon photonic integrated circuit of any of examples 31 to 46, wherein the silicon photonic integrated circuit is formed using a silicon layer and a III-V layer.
Example 48. The silicon photonic integrated circuit of example 47, wherein silicon distributed feedback laser comprises one or more gratings, wherein the one or more gratings are formed in the III-V layer and wherein the III-V layer having the one or more gratings is bonded to the silicon layer of the silicon photonic integrated circuit.
Example 49. The silicon photonic integrated circuit of any of examples 31 to 48, wherein the silicon photonic integrated circuit is a wavelength division multiplexing based device that comprises a plurality of symmetric silicon distributed feedback lasers, each symmetric silicon distributed feedback laser configured to output light from opposite sides of the symmetric silicon distributed feedback laser.
Example 50. A method for generating light in a silicon photonic integrated circuit comprising: generating, by a silicon distributed feedback laser in the silicon photonic integrated circuit, first light beam and a second light beam; outputting the first light beam from a first output side of the silicon distributed feedback laser and outputting the second light beam from a second output side of the silicon distributed feedback laser, the first output side and the second output side being opposite sides of the silicon distributed feedback laser; receiving the first light beam using a first waveguide in the silicon photonic integrated circuit; receiving the second light beam using a second waveguide in the silicon photonic integrated circuit;combining the first light beam and the second light beam using a silicon combiner of the silicon photonic integrated circuit; and outputting the combined light beam using a silicon output waveguide of the silicon photonic integrated circuit.
In the foregoing detailed description, the method and apparatus of the present inventive subject matter have been described with reference to specific example embodiments thereof. It will, however, be evident that various modifications and changes may be made thereto without departing from the broader spirit and scope of the present inventive subject matter. The present specification and figures are accordingly to be regarded as illustrative rather than restrictive.

## Claims

1. A silicon photonic integrated circuit comprising:
a silicon distributed feedback laser comprising a first output side and a second output side that is opposite of the first output side;
a plurality of silicon waveguides comprising a first waveguide to receive a first light beam from the first output side and a second waveguide to receive a second light beam from the second output side;
a silicon combiner to combine the first light beam from the first output side with the second light beam from the second output side into a combined light beam; and
a silicon output waveguide to output the combined light beam.

2. The silicon photonic integrated circuit of claim 1, further comprising: a heater to apply heat to one of the plurality of silicon waveguides.

3. The silicon photonic integrated circuit of claim 2, wherein the heater applies heat to phase match the first light beam and the second light beam, the first light beam and the second light beam being out of phase from the silicon distributed feedback laser.

4. The silicon photonic integrated circuit of claim 2 or 3, wherein the heater is a first heater that is proximate to the first waveguide.

5. The silicon photonic integrated circuit of claim 4, further comprising a second heater that is proximate to the second waveguide, for example wherein the second heater is configured to remain inactive while the first heater applies heat to phase match the first light beam and the second light beam.

6. The silicon photonic integrated circuit of claim 5, further comprising control circuitry configured to activate the first heater to apply heat while the second heater is inactive.

7. The silicon photonic integrated circuit of claim 6, wherein the control circuitry is configured to perform one or more selected from the group comprising:
activate the first heater while the second heater being inactive based on calibrations performed on the first heater and the second heater; and
apply a drive current to the silicon distributed feedback laser.

8. The silicon photonic integrated circuit of any preceding claim, wherein the silicon photonic integrated circuit is fabricated, and the silicon distributed feedback laser, the plurality of silicon waveguides, and the silicon combiner are formed using a same silicon wafer.

9. The silicon photonic integrated circuit of claim 8, wherein the plurality of silicon waveguides comprise low optical loss bends to couple light from the silicon distributed feedback laser to the silicon combiner, and/or wherein one or more of the plurality of silicon waveguides comprises a bend that is proximate to a heater in the silicon photonic integrated circuit to reduce heater power for phase matching.

10. The silicon photonic integrated circuit of any preceding claim, wherein the silicon distributed feedback laser is a symmetric silicon distributed feedback laser configured to generate laser light and output a first half of the laser light out the first output side and output a second half of the laser light out the second output side.

11. The silicon photonic integrated circuit of any preceding claim, wherein the silicon distributed feedback laser does not comprise reflectivity coatings on the first output side and the second output side.

12. The silicon photonic integrated circuit of any preceding claim, wherein the silicon combiner is a multimode interference coupler.

13. The silicon photonic integrated circuit of any preceding claim, wherein the silicon photonic integrated circuit is formed using a silicon layer and a III-V layer, for example wherein the silicon distributed feedback laser comprises one or more gratings, wherein the one or more gratings are formed in the III-V layer and wherein the III-V layer having the one or more gratings is bonded to the silicon layer of the silicon photonic integrated circuit.

14. The silicon photonic integrated circuit of any preceding claim, wherein the silicon photonic integrated circuit is a wavelength division multiplexing based device that comprises a plurality of symmetric silicon distributed feedback lasers, each symmetric silicon distributed feedback laser configured to output light from opposite sides of the symmetric silicon distributed feedback laser.

15. A method for generating light in a silicon photonic integrated circuit comprising:
generating, by a silicon distributed feedback laser in the silicon photonic integrated circuit, first light beam and a second light beam;
outputting the first light beam from a first output side of the silicon distributed feedback laser and outputting the second light beam from a second output side of the silicon distributed feedback laser, the first output side and the second output side being opposite sides of the silicon distributed feedback laser;
receiving the first light beam using a first waveguide in the silicon photonic integrated circuit;
receiving the second light beam using a second waveguide in the silicon photonic integrated circuit;
combining the first light beam and the second light beam using a silicon combiner of the silicon photonic integrated circuit; and
outputting the combined light beam using a silicon output waveguide of the silicon photonic integrated circuit.
